# EUROPÄISCHE PATENTSCHRIFT

(11) **EP 1 468 492 B1**
(45) Veröffentlichungstag und Bekanntmachung des Hinweises auf die Patenterteilung: **05.07.2006**
(21) Anmeldenummer: 02796524.3
(22) Anmeldetag: 30.12.2002
(51) Int. Cl.: H03K 3/356

(54) **INTEGRIERTE SCHALTUNG UND SCHALTUNGSANORDNUNG ZUR UMWANDLUNG EINES SINGLE-RAIL-SIGNALS IN EIN DUAL-RAIL-SIGNAL**
INTEGRATED CIRCUIT AND CIRCUIT ARRANGEMENT FOR CONVERTING A SINGLE-RAIL SIGNAL TO A DUAL-RAIL SIGNAL
CIRCUIT INTEGRE ET SYSTEME DE CIRCUIT PERMETTANT LA TRANSFORMATION D'UN SIGNAL RAIL SIMPLE EN UN SIGNAL RAIL DOUBLE

(30) Priorität: 24.01.2002 DE 10202725
(43) Veröffentlichungstag der Anmeldung: 20.10.2004
(73) Patentinhaber: Infineon Technologies AG, 81669 München (DE)
(72) Erfinder: KÜNEMUND, Thomas, 80337 München (DE)
(74) Vertreter: Epping - Hermann - Fischer
(86) Internationale Anmeldenummer: PCT/DE2002/004753
(87) Internationale Veröffentlichungsnummer: WO 2003/063355

(56) Entgegenhaltungen:
- US-A- 4 149 099
- US-A- 4 435 791
- US-A- 4 751 681
- US-A- 5 825 224
- US-A- 6 081 153
- PATENT ABSTRACTS OF JAPAN vol. 005, no. 153 (E-076), 26. September 1981 (1981-09-26) & JP 56 086527 A (NEC CORP), 14. Juli 1981 (1981-07-14)

## Beschreibung

Die Erfindung betrifft die schaltungstechnische Realisierung von Registern für Dateneingänge von Dual-Rail-Logik-Schaltnetzen.

Schaltnetze, z. B. ein 1-aus-n-Decoder sind üblicherweise mikroelektronisch ausgeführt. Dies bedeutet, daß jedes Bit in einem dem Schaltnetz vorgeschalteten Register gespeicherten Zustand physikalisch durch genau einen Wert am Registerausgang dargestellt wird. Für die deshalb sogenannte "Single-Rail"-Schaltungstechnik gilt Gleiches auch für alle Knoten innerhalb der Schaltnetze sowie für deren Eingänge. Dem logischen Wert eines Zustands-Bits bzw. dessen komplementären Wert entspricht genau ein elektrischer Knoten. Schaltnetze, die in Single-Rail-Technik realisiert sind, können jedoch auf einfache Weise, z. B. mit der sogenannten "Differentiellen Stromprofilanalyse", ausspioniert werden.

Die differentielle Stromprofilanalyse (differential power analysis, DPA) ist eine der wichtigsten Methoden zum Angriff auf Chipkarten im Hinblick auf vertrauliche Informationen wie in der Chipkarte abgespeicherte Paßwörter oder kryptographische Schlüssel. Dabei werden bei einem vorgegebenen Programm bzw. einem vorgegebenen Algorithmus mit statistischen Methoden gemessene Stromprofile bzw. deren über einen oder mehrere Taktzyklen berechnete Ladungsintegrale der Chipkarte ausgewertet. Bei einer ausreichend großen Anzahl von Programmausführungen kann aus der Korrelation einer systematischen Datenvariation und dem jeweiligem Ladungsintegral Rückschluß auf die zu schützende Information gezogen werden.

Um einen Angriff mit der differentiellen Stromprofilanalyse zu erschweren, können Schaltnetze deshalb in sogenannter "Dual-Rail"-Technologie ausgeführt werden. Im Gegensatz zur herkömmlichen Single-Rail-Logik, bei der jedes Bit innerhalb eines Daten- oder Signalpfades physikalisch durch genau einen elektrischen Knoten eines Schaltnetzes dargestellt wird, wird bei einer Realisierung mit Dual-Rail-Logik jedes Bit durch zwei Knoten k und kq dargestellt. Das Bit weist dann einen gültigen logischen Wert auf, wenn k dem wahren logischen Wert b dieses Bits entspricht und kq dem negierten Wert bn = not (b) .

Die erwünschte Invarianz der Ladungsintegrale wird dadurch erreicht, daß zwischen je zwei Zustände mit gültigen logischen Werten (b, bn) = (1,0) oder (0,1.) ein sogenannter Vorlade-Zustand (precharge) eingefügt ist, für den sowohl der Knoten k als auch der Knoten kq auf das selbe elektrische Potential geladen werden. Die Knoten bzw. Signalleitungen nehmen folglich logisch ungültige Werte (1,1) oder (0,0) an. Für den Vorlade-Zustand (1,1) könnte also eine Zustandsfolge in einem Daten- oder Signalpfad mit dem Knoten k, kq wie folgt aussehen:
(1, 1) (0, 1) (1, 1) (1, 0) (1, 1) (1, 0) (1, 1) (0, 1), ...

Für jede beliebige solcher Zustandsfolgen gilt, daß bei jedem Übergang von einem Vorlade-Zustand auf einen logisch gültigen Wert genau ein Knoten von 1 nach 0 umgeladen wird und bei jedem Übergang von einem logisch gültigen Wert zu einem Vorlade-Zustand genau 1 Knoten von 0 nach 1 umgeladen wird. Dies ist unabhängig von dem logisch gültigen Wert b eines jeweiligen Zustandsbits.

Hieraus folgt, daß die diesen Zustandsfolgen entsprechenden Ladungsintegrale unabhängig sind von der Abfolge der logisch gültigen Werte (b, bn), sofern Sorge dafür getragen wird, daß die Knoten k und kq gleiche elektrische Kapazitäten aufweisen. Das Stromprofil eines derart realisierten Datenpfades hängt somit nicht von der zeitlichen Variation der zu verarbeitenden Daten ab. Somit führt eine differentielle Stromprofilanalyse nicht zum Ziel.

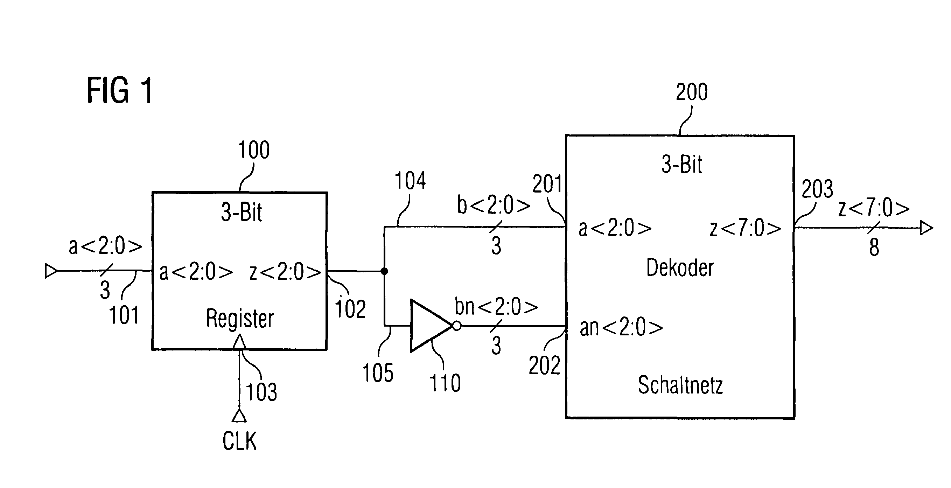

Anhand der Figuren 1 bis 4 wird nachfolgend beschrieben, auf welche Weise eine Dual-Rail-Implementierung im Stand der Technik realisiert ist.

Figur 1 zeigt ein Blockschaltbild mit einem Schaltnetz 200, das beispielhaft als 1-aus-n-Decoder ausgeführt ist. Das Schaltnetz ist in Dual-Rail-Technologie ausgeführt, so daß der Dateneingang des Schaltnetzes pro Bit zwei Eingangsanschlüsse 201, 202 aufweist, an die das Dual- Rail- Signal b<2:0>, bn<2:0> anlegbar ist. Im Inneren des Schaltnetzes 200 werden die Eingangssignale a<2:0>, an<:0> genannt. Dem Dateneingang des Schaltnetzes 200 sind ein Register 100 sowie ein Inverter 110 vorangeschaltet, welche die Umsetzung eines Single-Rail-Signales in ein Dual-Rail-Signal vornimmt und dieses dem Schaltnetz 200 zur Verfügung stellt. An einem Dateneingang 101 des Registers 100 liegt ein Single-Rail-Signal a<2:0> an. Das Register 100 verfügt ferner über einen Taktsignalanschluß 103, an dem ein Taktsignal CLK anliegt.

Mit jeder steigenden Taktflanke wird das an dem Dateneingang 101 anliegende Single-Rail-Signal an den Datenausgang 102 abgegeben. Das dort abgreifbare Signal wird als z<2:0> bezeichnet. Die Umsetzung auf ein Dual-Rail-Signal erfolgt, indem das Ausgangssignal z<2:0> einmal direkt dem Eingangsanschluß 201 des Schaltnetzes 200 und einmal über einen Inverter 110 dem Eingangsanschluß 202 des Schaltnetzes 200 zugeführt wird. Der Datenausgang 102 des Registers 100 ist somit mit zwei Ausgangsleitungen 104, 105 verbunden, wovon die eine direkt und die andere über den Inverter 110 mit dem Schaltnetz 200 verbunden ist. Das Dual-Rail-Signal setzt sich somit aus den Signalen b<2:0> und bn<2:0> zusammen.

Im vorliegenden Ausführungsbeispiel der Figur 1 wird davon ausgegangen, daß es sich bei dem Register 100 um ein 3-Bit-Register und bei dem Schaltnetz 200 um einen 3-Bit-Decoder handelt. Die gewählten Bitbreiten sind lediglich als Beispiel anzusehen. Selbstverständlich könnte sowohl das Register als auch das Schaltnetz eine andere Bitbreite aufweisen.Am Datenausgang des Schaltnetzes 200 liegt beispielhaft ein 8-Bit breites Signal z<7:0> an. Bei dem Schaltnetz muß es sich auch nicht, wie im vorliegenden Ausführungsbeispiel gewählt, um einen 1-aus-8-Decoder handeln. Das Schaltnetz kann vielmehr beliebiger Art sein.

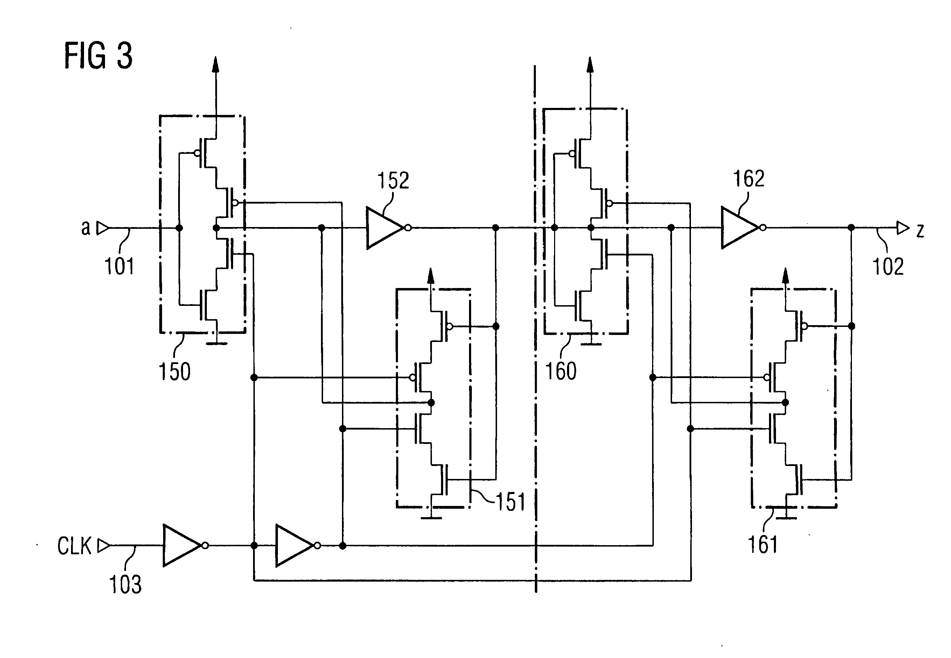

Das bzw. die drei Register 100 sind, wie in Figur 3 näher dargestellt, beispielsweise als Master-Slave-Register ausgeführt. Sowohl der Master, der links der strichpunktierten Linie dargestellt ist, als auch der Slave sind als sogenannte "Daten-Latches" ausgeführt, die im Gegentakt geschaltet werden. Das Daten-Latch des Masters besteht aus einem C²MOS-Schalter 150 der mit einem ebenfalls als C²MOS-Schalter ausgeführten Rückkoppel-Inverter 151 verbunden ist. Das Daten-Latch des Slave ist in entsprechender Weise aus C²MOS-Schaltern aufgebaut und dem Daten-Latch des Masters nachgeschaltet. Da der konstruktive Aufbau eines derartigen Registers aus dem Stand der Technik seit langem bekannt ist, wird an dieser Stelle auf eine ausführlichere Beschreibung verzichtet.

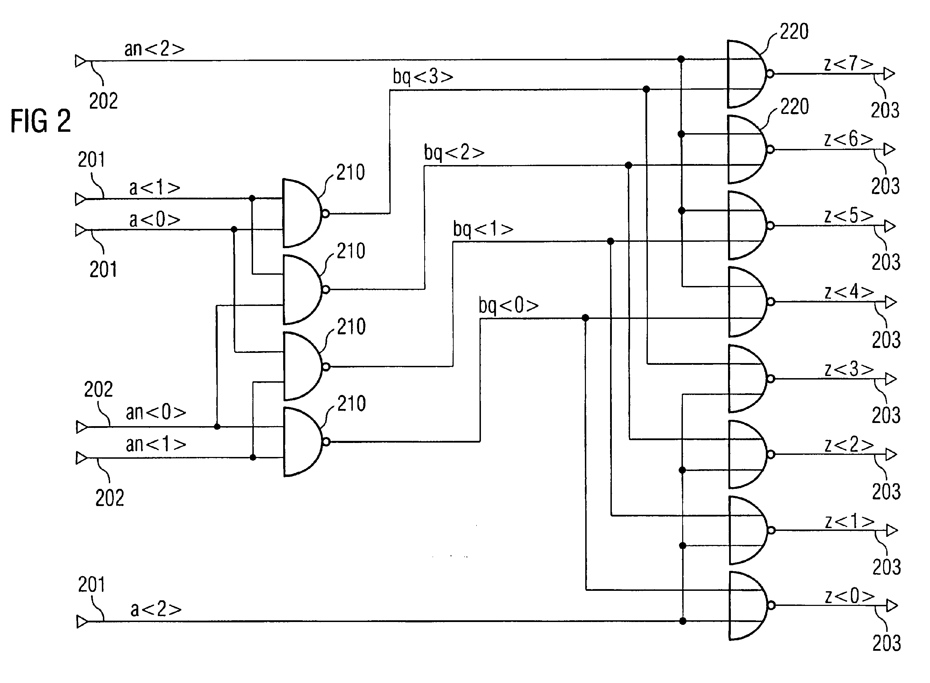

Der Aufbau des 1-aus-8-Dekoders aus Figur 1 ist in Figur 2 dargestellt. Aus dieser Figur wird gut ersichtlich, daß das Schaltnetz 200 über insgesamt sechs Eingangsanschlüsse verfügt, wobei pro Bit zwei Eingangsanschlüsse 201, 202 vorgesehen sind. Wie bereits bei Figur 1 beschrieben, liegt an dem Eingangsanschluß 201 das logisch gültige Signal a<0>, a<1>, a<2>, während an dem Eingangsanschluß 202 das jeweils komplementäre Signal an<0>, an<1>, an<2> anliegt. Da es sich bei dem Schaltnetz 200 um einen 1-aus-8-Decoder handelt, verfügt dieser über insgesamt acht Datenausgänge 203, an denen jeweils ein Signal z<0>, ... z<7> anliegt. Die schaltungstechnische Realisierung erfolgt in bekannter Weise über NAND-Gatter 210, deren Ausgänge mit den Eingängen von NOR-Gattern 220 verschaltet sind. Die an den Ausgängen der NAND-Gatter 210 anliegenden Signale werden als bq<0>,... bq<3> bezeichnet. Der genaue Aufbau des Decoders ist aus dem Stand der Technik bekannt, so daß auch hier auf eine ausführliche Beschreibung verzichtet wird.

Ein Beispiel für den zeitlichen Ablauf der in Figur 1 und 3 dargestellten Signale und des Taktsignals CLK ist in Figur 4 wiedergegeben. Neben dem Taktsignal CLK sind das am Dateneingang 101 anliegende Signal a<2:0> des Registers 100, das den Eingangsanschlüssen 201, 202 zugeführte Dual-Rail-Signal b<2:0>, bn<2:0>, das von den NAND-Gattern 210 erzeugte Signal bq<3:0> und das am Datenausgang 203 des Schaltnetzes 200 abgreifbare Signal z<7:0> dargestellt.

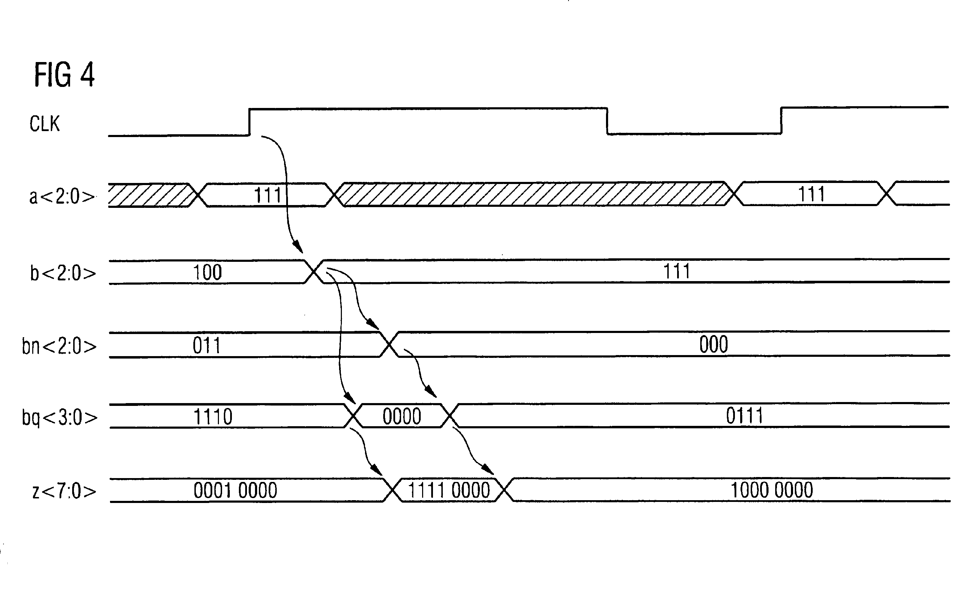

Für dieses Beispiel wird nun angenommen, daß im Takt vor der ersten in Figur 4 dargestellten steigenden Taktflanke des Signales CLK der Wert "100" in das 3-Bit-Register 100 geschrieben wurde, so daß zunächst gilt:
b<2:0> = "100", bn<2:0> = "011",
bq<3:0> = "1110" und
z<7:0> = "001 0000".

Mit der ersten steigenden Flanke des Taktsignals CLK wird nun der Wert a<2:0> = "111" am Dateneingang 101 in das Register 100 übernommen. Dieser Wert wird an den Datenausgang 102 des Registers weitergegeben, so daß zunächst auf der Ausgangsleitung 104 und somit am Eingangsanschluß 201 das Signal b<2:0> und, aufgrund der endlichen Schaltzeit des Inverters 110, erst danach am Eingangsanschluß 202 das dazu inverse Signal bn<2:0> anliegt. Da die Signalwerte an den Eingangsanschlüssen 201, 202 zu unterschiedlichen Zeiten anliegen, tritt der Effekt auf, daß das Zwischensignal bq<3:0> von seinem Ausgangswert "1110" zunächst kurzzeitig in einen logisch ungültigen Zwischenzustand "0000" übergeht, bevor der stabile Endwert "0111" erreicht wird. Damit liegt auch am Datenausgang 203 des Schaltnetzes 200 kurzzeitig ein logisch ungültiger Zwischenzustand an: ausgehend von einem Wert z<7:0> = "0001 0000" liegt kurzzeitig der logisch ungültige Zwischenzustand "1111 0000" an, bevor der stabile Endwert "1000 0000" erreicht wird.

Mit der zweiten steigenden Taktflanke des Taktsignals CLK liegt nun erneut der Wert a<2:0> = "111" an den Dateneingängen 101 der Register 100 an. Folglich ändern sich weder die Signale b<2:0>, bn<2:0>, bq<3:0> und z<7:0>.

Aus diesem Beispiel wird der Nachteil der im Stand der Technik eingesetzten Schaltungsanordnung ersichtlich: Abhängig von der zeitlichen Verschiebung der an den Eingangsanschlüssen 201, 202 anliegenden Signale b, bn kann der Datenausgang 203 des Schaltnetzes 200 kurzzeitig logisch ungültige Zwischenzustände durchlaufen, was in dem Schaltnetz 200 nachgeschalteten Schaltungsblöcken zu Störungen oder erhöhtem schaltungstechnischen Aufwand führen kann. Weiterhin bedeuten die mit diesen Zwischenzuständen verbundenen überflüssigen Signalwechsel physikalisch, daß die jeweiligen elektrischen Kapazitäten unnötig umgeladen werden müssen, wodurch ein erhöhter Energieumsatz notwendig ist. Darüber hinaus hängt das Stromprofil des Registers und des Schaltnetzes stark ab von den jeweils zu verarbeitenden Eingangsdaten a bzw. a, an, so daß die Schaltungsanordnung insgesamt trotz Einsatz der Dual-Rail-Technologie anfällig für eine differentielle Stromprofilanalyse ist.

Die Aufgabe der vorliegenden Erfindung besteht deshalb darin, eine integrierte Schaltung und eine Schaltungsanordnung zur Umwandlung eines Single-Rail-Signals in ein Dual-Rail-Signal anzugeben, bei der die oben stehenden Nachteile auf einfache Weise vermieden werden.

Diese Aufgabe wird durch eine integrierte Schaltung gemäß den Merkmalen des Patentanspruches 1 sowie durch eine Schaltungsanordnung mit den Merkmalen des Patentanspruches 9 gelöst. Vorteilhafte Ausgestaltungen ergeben sich aus den abhängigen Ansprüchen.

Das Mittel zum Umwandeln des Single-Rail-Signals in das Dual-Rail-Signal umfaßt eine Speicherzelle, deren Eingang mit dem Dateneingang der integrierten Schaltung verbunden ist und an dessen Ausgang im transparenten Zustand das logisch gültige Dual-Rail-Signal durchgeschaltet wird, wobei eine zwischen dem Ausgang der Speicherzelle und dem Datenausgang der integrierten Schaltung angeordnete Schaltungsanordnung das Vorladen der Ausgangsleitungen übernimmt und einen direkten Übergang von der Vorladephase in den logischen Zustand auf den Ausgangsleitungen und umgekehrt sicherstellt.

Die Erfindung vermeidet logisch ungültige Zwischenzustände dadurch, daß das Dual-Rail-Signal nicht unmittelbar nach dessen Erzeugung an den Datenausgang abgegeben werden kann. Bewerkstelligt wird dies durch die zwischen der Speicherzelle und dem Datenausgang geschaltete Schaltungsanordnung. Diese sorgt einerseits für das Vorladen der Ausgangsleitungen. Das Vorladen erfolgt dabei bei immer dem gleichen Taktzustandswert (low oder high). In dem anderen Taktzustandswert (high oder low) wird dann der Vorlademechanismus von dem Datenausgang getrennt und gleichzeitig das am Eingang der Schaltungsanordnung anliegende Dual-Rail-Signal, d.h. die beiden Ausgangssignale der Speicherzelle, direkt auf den Datenausgang, der zwei Ausgangsleitungen umfaßt, ausgegeben. An den Eingangsanschlüssen eines der erfindungsgemäßen integrierten Schaltung nachgeschalteten Schaltnetzes kommt somit das logisch gültige Signal und dessen komplementärer Wert gleichzeitig an. Damit können in dem nachgeschalteten Schaltwerk keine logisch ungültigen Zwischenzustände auftreten.

Vorzugsweise erfolgt ein Vorladen der Ausgangsleitungen der integrierten Schaltung nach jeder fallenden oder steigenden Taktflanke des Taktsignals. Mit anderen Worten erfolgt der Vorladevorgang immer dann, wenn das Taktsignal low oder high ist. Hierdurch ergibt sich eine hohe Performance der integrierten Schaltung.

In einer Weiterbildung der Erfindung ist vorgesehen, daß der Speicherzelle an einem ersten Taktsignaleingang das Taktsignal zugeführt wird. Weiterhin ist vorgesehen, daß der Speicherzelle an einem zweiten Taktsignaleingang das invertierte Taktsignal zugeführt wird. Wenn die Speicherzelle, wie in einer bevorzugten Ausgestaltung vorgesehen, als Daten-Latch ausgeführt ist, kann dieses in einen transparenten oder eingerasteten Zustand gebracht werden. Im transparenten Zustand wird das am Dateneingang anliegende Signal direkt auf den Ausgang des Daten-Latch durchgeschaltet.

In einer Weiterbildung verfügt die Schaltungsanordnung über eine Cascode Voltage Switch Logik (CVSL), deren Eingangsanschlüsse mit dem Ausgang der Speicherzelle verbunden sind und deren Ausgangsanschlüsse die Ausgangsleitungen der integrierten Schaltung darstellen. Die Cascode Voltage Switch-Logik, die prinzipiell aus dem Stand der Technik bekannt ist, sorgt dafür, daß das an ihrem Eingang anliegende Dual-Rail-Signal eindeutig am Datenausgang der erfindungsgemäßen integrierten Schaltung anliegt. Hierunter wird verstanden, daß keine der Ausgangsleitungen einen undefinierten Zustand zwischen einem high- oder low-Level annehmen darf.

Um mittels der Cascode Voltage Switch-Logik ein Vorladen der Ausgangsleitungen zu ermöglichen, weist die Schaltungsanordnung vorteilhafterweise ein erstes und ein zweites Schaltelement auf, deren Steueranschlüsse jeweils mit dem Taktsignal bzw. dem invertierten Taktsignal gekoppelt sind und deren Laststrecken zwischen einem ersten bzw. zweiten Versorgungspotentialanschluß und je einer der Ausgangsleitungen verschaltet sind, wobei das erste und zweite Schaltelement im transparenten Zustand der Speicherzelle eingeschaltet sind.

Befindet sich die Speicherzelle nicht im transparenten Zustand, so sind die beiden Schaltelemente ausgeschaltet und werden durch die Cascode Voltage Switch Logik, die ja ebenfalls mit den Ausgangsleitungen gekoppelt ist, angesteuert. Hierdurch kann ein direkter Übergang von dem Vorladezustand in den logischen Zustand auf den Ausgangsleitungen und umgekehrt erfolgen.

Werden mehrere der erfindungsgemäßen integrierten Schaltungen in einer Schaltungsanordnung vorgesehen, so kann das Eingangssignal entsprechend der Anzahl der integrierten Schaltungen mehrere Bit breit sein.

Die Erfindung und deren Vorteile werden nachfolgend anhand der Figuren näher beschrieben. Es zeigen:
Figur 1 ein Blockschaltbild einer aus dem Stand der Technik bekannten Anordnung aus einem Register und einem nachgeschalteten Schaltnetz,
Figur 2 den prinzipiellen Aufbau des Schaltnetzes aus Figur 1 in Form eines 1-Aus-8-Decoders,
Figur 3 eine schaltungstechnische Realisierung des in Figur 1 gezeigten Registers,
Figur 4 den zeitlichen Ablauf der Signale aus Figur 1,

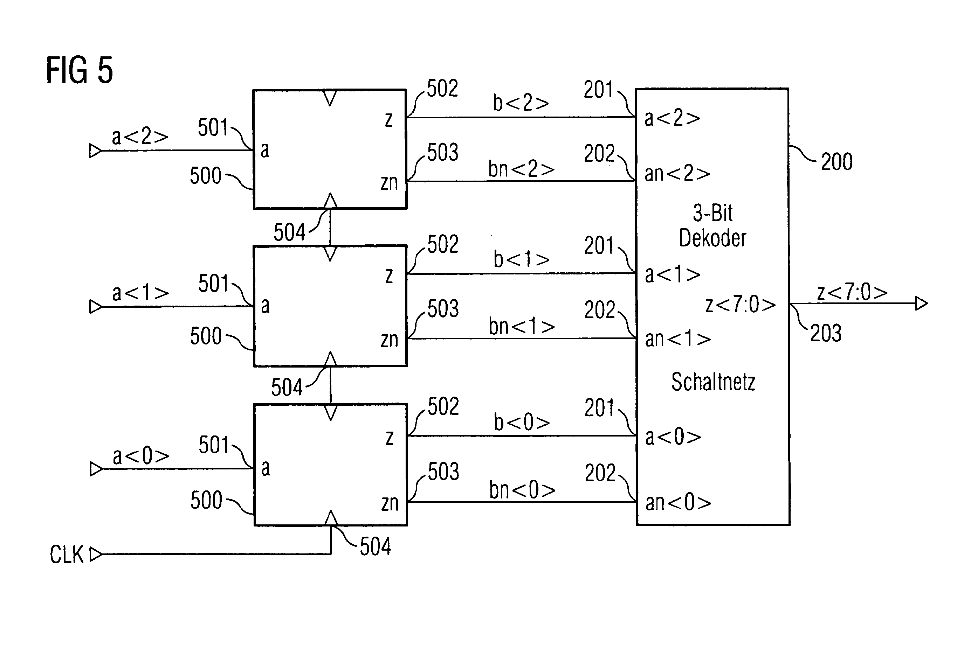

Figur 5 den prinzipiellen Aufbau einer erfindungsgemäßen Schaltungsanordnung mit nachgeschaltetem Schaltnetz,

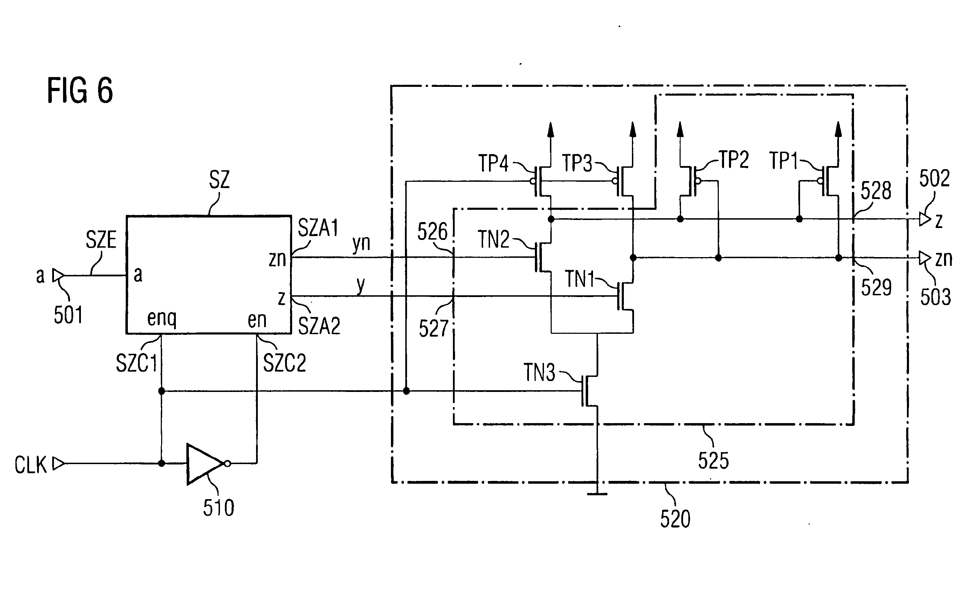

Figur 6 ein erstes Ausführungsbeispiel einer erfindungsgemäßen integrierten Schaltung, mit der eine Vorladung der Ausgangsleitungen auf den Wert (1,1) realisierbar ist,

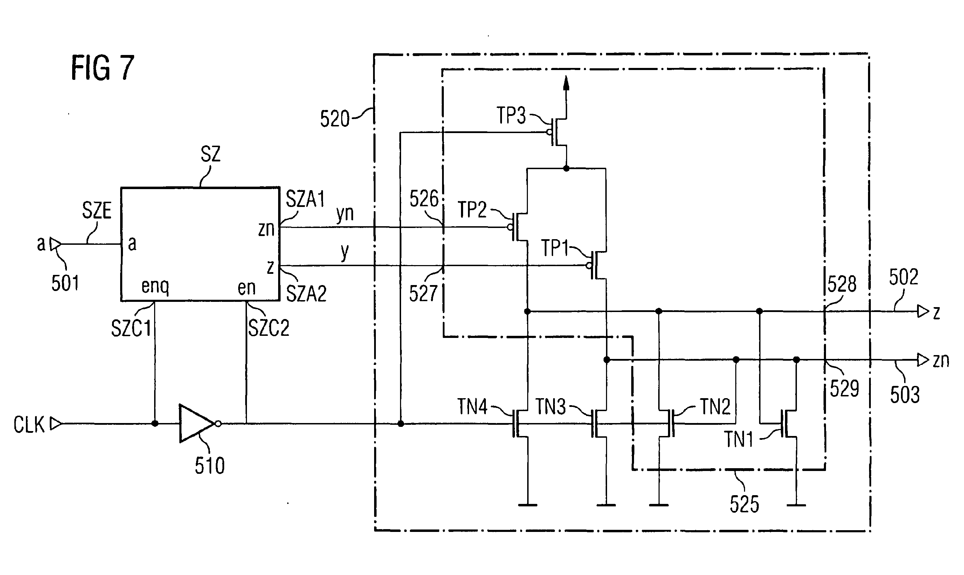

Figur 7 ein zweites Ausführungsbeispiel einer erfindungsgemäßen integrierten Schaltung, mit der eine Vorladung der Ausgangsleitungen auf (0,0) möglich ist,

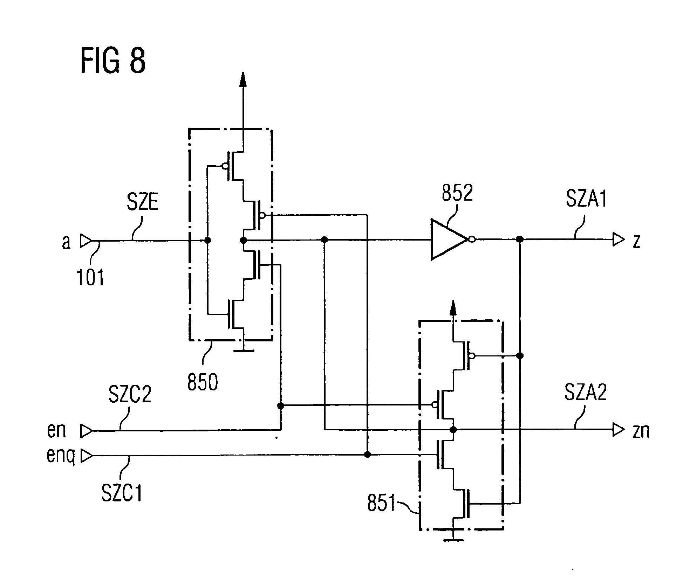

Figur 8 ein Ausführungsbeispiel für die schaltungstechnische Realisierung der Speicherzelle aus den Figuren 6 und 7 und

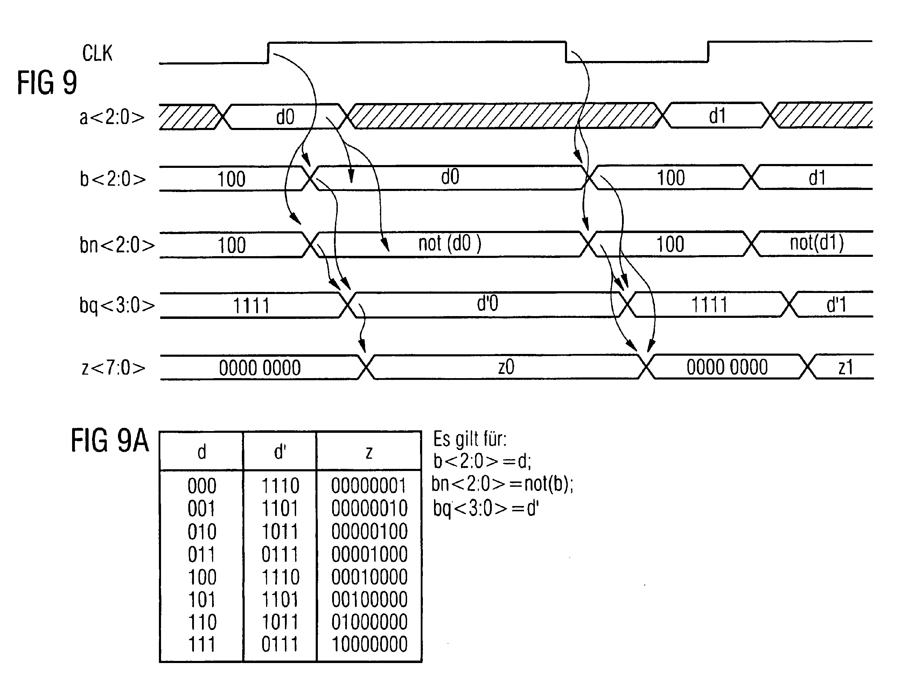

Figur 9 den zeitlichen Ablauf der Signale der Schaltungsanordnung aus Figur 5.

Figur 5 zeigt ein Blockschaltbild einer erfindungsgemäßen Schaltungsanordnung mit drei Registern 500. Jedes der Register 500 weist einen Dateneingang 501 auf, an dem ein Signal a<0>, a<1>, a<2> anliegt. Jedes der Register verfügt über Ausgangsanschlüsse 502, 503, die zusammen einen Datenausgang des Registers 500 bilden. Während am Dateneingang 501 ein Single-Rail-Signal anliegt, ist an dem Datenausgang bzw. an den Ausgangsanschlüssen 502, 503 ein Dual-Rail-Signal abgreifbar, welches aus dem logisch gültigen Wert b<0>, b<1>, b<2> und den jeweils komplementären Wert bn<0>, bn<1>, bn<2> besteht. Jedes der Register 500 verfügt über einen Taktsignalanschluß 504, an dem ein Taktsignal CLK anliegt

Die Ausgangsanschlüsse 502, 503 eines jeden Registers 500 sind mit Eingangsanschlüssen 201, 202 eines Schaltnetzes 200 verbunden. Lediglich beispielhaft ist das Schaltnetz 200 als 3-Bit-Decoder-Schaltnetz ausgeführt, welches einen 1-aus-8-Decoder darstellt. Prinzipiell könnte der Aufbau des Schaltnetzes jedoch beliebiger Natur sein. Dies bedeutet, es könnte sich auch um einen n-Bit-Decoder handeln, so daß eine entsprechende Anzahl n an Registern 500 für je den Dateneingang des Schaltnetzes 200 vorgesehen werden müßte. Der schaltungstechnische Aufbau des Schaltnetzes 200 ist dem gemäß in Figur 2 wiedergegeben.

In den Figuren 6 und 7 ist in einem ersten bzw. zweiten Ausführungsbeispiel der Aufbau eines Registers 500, also einer integrierten Schaltung zur Umwandlung eines Single-Rail-Signals in ein Dual-Rail-Signal dargestellt. Die beiden Ausführungsbeispiele weisen einen prinzipiell ähnlichen Aufbau auf und unterscheiden sich darin, daß die Ausführungsvariante gemäß Figur 6 die mit den Ausgangsanschlüssen 502, 503 verbundenen Ausgangsleitungen auf einen Vorladezustand (1,1) bringt, während das Ausführungsbeispiel gemäß Figur 7 einen Vorladezustand (0,0) zur Verfügung stellt.

Die Register weisen jeweils eine Speicherzelle SZ auf, die als Daten-Latch ausgebildet ist. Der Eingang SZE des Daten-Latch ist mit dem Dateneingang 501 des Registers verbunden. Das Daten-Latch SZ verfügt über zwei Ausgangsanschlüsse SZA1, SZA2, an denen im transparenten Zustand das Dual-Rail-Signal zn, z bzw. yn, y anliegt. Das Daten-Latch verfügt weiterhin über einen ersten Taktsignaleingang SZC1, an dem das Taktsignal CLK anliegt und über einen zweiten Taktsignaleingang SZCZ, an dem das invertierte Taktsignal CLK anliegt.

Damit nach einem Vorladezustand das Dual-Rail-Signal y, yn verzögerungsfrei an die Ausgangsanschlüsse 502, 503 und somit an die Eingangsanschlüsse 201, 202 eines nachgeschalteten Schaltnetzes (Figur 5)weitergegeben werden kann, ist die Schaltungsanordnung 520 vorgesehen.

Die Schaltungsanordnung 520 besteht in beiden Ausgestaltungsvarianten aus einer Cascode Voltage Switch-Logik 525 sowie aus einem ersten und zweiten Schaltelement TP3, TP4 (Figur 6) bzw. TN3, TN4 (Figur 7).

Die bislang beschriebene Ausgestaltung ist bei beiden Varianten des erfindungsgemäßen Registers identisch. Nachfolgend wird bei der Beschreibung der Schaltungsanordnung 520 zunächst auf die Figur 6 Bezug genommen, die sich von der aus Figur 7 unterscheidet.

Wie eingangs bereits erwähnt, erzeugt die integrierte Schaltung gemäß Figur 6 einen Vorladezustand (1,1) an den mit den Ausgangsanschlüssen 502, 503 verbundenen Ausgangsleitungen. Zu diesem Zweck sind die Ausgangsanschlüsse 502, 503 über das zweite Schaltelement TP3 bzw. erste Schaltelement TP4 mit einem Versorgungspotential VDD verbindbar. Das erste und das zweite Schaltelement TP3, TP4 sind als P-Kanal-Transistoren ausgeführt. Deren Steueranschlüsse sind jeweils mit dem Taktsignal CLK beaufschlagt. Dies bedeutet, daß die Ausgangsanschlüsse 502, 503 immer dann auf (1,1) vorgeladen werden, wenn das Taktsignal CLK low ist.

Die Cascode Voltage Switch-Logik 525, bestehend aus den N-Kanal-Transistoren TN1, TN2, TN3 und den P-Kanal-Transistoren TP1, TP2 sorgt dafür, daß mit der steigenden Flanke des Taktsignals CLK die an den Ausgangsanschlüssen SZA1, SZA2 des Daten-Latch SZ abgreifbaren Signale y, yn an die Ausgangsanschlüsse 502, 503 weitergegeben werden. Solange das Taktsignal CLK high ist, ist das Daten-Latch eingerastet und behält somit den Signalwert y, yn.

Sobald das Taktsignal CLK den Wert 1 (entspricht high) annimmt, so werden das erste und zweite Schaltelement TP3, TP4 abgeschaltet. Gleichzeitig verbindet der Transistor TN3 die Transistoren TN1, TN2 mit dem Bezugspotential VSS. Am Steueranschluß des Transistors TN1 liegt das logisch gültige Signal y an, während am Steueranschluß des N-Kanal-Transistors TN2 das komplementäre Signal yn anliegt. An einem der Ausgangsanschlüsse 502, 503 liegt somit der Wert 0 (entspricht low) an, da eine direkte Verbindung über TN2, TN3 bzw. TN1, TN3 mit dem Bezugspotential VSS besteht. Derjenige der P-Kanal-Transistoren TP1, TP2, dessen Steueranschluß mit diesem Ausgangsanschluß 502, 503 verbunden ist, verbindet dann den anderen Ausgangsanschluß 502, 503 mit dem Versorgungspotential VDD. Die Transistoren TP1, TP2 sorgen also dafür, daß an den Ausgangsanschlüssen 502, 503 eindeutige Signale z, zn anliegen.

Weist das Taktsignal CLK den logischen Wert 0 auf, so ist das Daten-Latch SZ transparent, das heißt, es besteht eine direkte Verbindung zwischen dem Dateneingang SZE und den Ausgangsanschlüssen SZA1, SZA2. Gleichzeitig werden die Ausgangsanschlüsse 502, 503 über das erste und zweite Schaltelement TP3, TP4 auf 1 vorgeladen.

Die Funktionsweise und der Aufbau der zweiten Ausgestaltungsvariante gemäß Figur 7 ist analog. Auch hier wird das Daten-Latch SZ bei einem Taktsignal CLK = 0 transparent. Die mit den Ausgangsanschlüsse 502, 503 verbundenen Leitungen werden über die N-Kanal-Transistoren TN3, TN4, deren Steueranschlüsse mit dem invertierten Taktsignal beaufschlagt werden, auf (0,0) vorgeladen. Der P-Kanal-Transistor TP3, der Bestandteil der Cascode Voltage Switch-Logik ist, ist für CLK = 0 ausgeschaltet, so daß das an den Datenausgängen SZA1, SZA2 anliegende Dual-Rail-Signal y, yn nicht zu den Ausgangsanschlüssen 502, 503 des Registers gelangen kann.

In entsprechender Weise ist dies erst dann möglich, sobald das Taktsignal CLK eine steigende Flanke annimmt. Nimmt das Taktsignal den logischen Wert 1 an, so werden das erste und das zweite Schaltelement TN3, TN4 abgeschaltet. Der Transistor TP3 verbindet die P-Kanal-Transistoren TP1, TP2 mit Versorgungspotential VDD. Diese werden ihrerseits an ihren Steuereingängen mit den Signalen y, yn beaufschlagt. Die N-Kanal-Transistoren TN1, TN2 dienen wiederum dazu, an den Ausgangsanschlüssen 502, 503 komplementäre Signale anliegen zu lassen.

Bei beiden Varianten ist sichergestellt, daß an den Ausgangsanschlüssen 502, 503 gleichzeitig das Dual-Rail-Signal anliegt, so daß ein nachgeschaltetes Schaltwerk keine logisch ungültigen Zwischenzustände aufweisen kann.

Der zeitliche Ablauf der Signale und des Taktsignals CLK der Schaltungsanordnung aus Figur 5 ist in Figur 9 wiedergegeben. Das Signal a<2:0> liegt am Dateneingang 501 des Registers 500 an. Das Signal b<2:0> ist dem Ausgangsanschluß 502 entnehmbar, das Signal bn<2:0> liegt am Ausgangsanschluß 503 an. Diese Signale werden somit den Eingangsanschlüssen 201, 202 eines nachgeschalteten Schaltnetzes (vergleiche Figur 5) zugeführt. Das Signal bq<3:0> stellt das in Figur 2 bereits erläuterte Ausgangssignal der NAND-Gatter dar. Es handelt sich hierbei somit um ein Signal, das im Inneren des Schaltnetzes 200 auftaucht. Mit z<7:0> ist schließlich das Ausgangssignal des Schaltwerkes 200 bezeichnet.

Für CLK = 0 befinden sich die an den Ausgangsanschlüssen 502, 503 anliegenden Signale b<2>, bn<2> und b<1:0>, bn<1:0> eines jeden Daten-Latch SZ in ihren Vorladezuständen (1,1) und (00,00). Dies ergibt sich daraus, daß das oberste in Figur 5 dargestellte Register 500 gemäß Figur 6 ausgebildet ist, während die beiden anderen Register 500 gemäß Figur 7 ausgebildet sind. Diese Annahme stellt lediglich ein Beispiel dar. Prinzipiell sind die Register 500 beliebig gemäß Figur 6 oder 7 einsetzbar. Maßgeblich ist lediglich, welcher Vorladezustand an den Eingängen eines Schaltnetzes anliegen soll.

Gemäß der oben beschriebenen Funktionsweise der Register 500 befinden sich beim Taktsignal CLK = 0 auch die Signale bq<3:0> und z<7:0> in ihren Vorladezuständen "1111" bzw. "0000 0000". Mit der steigenden Flanke des Taktsignals CLK wird das Dual-Rail-Signal y, yn an den Ausgangsanschlüssen SZA1, SZA2 an die Ausgangsanschlüsse 502, 503 des Registers 500 weitergegeben. Die an den Dateneingängen 501 anliegenden Signale sind in der Figur 9 mit "d" bezeichnet, wobei in der Tabelle gemäß Figur 9a die Werte angegeben sind, die d annehmen kann. Entsprechend dem Prinzip der Dual-Rail-Technologie liegt kurze Zeit nach einer steigenden Taktflanke CLK am Ausgangsanschluß 502 ebenfalls das Signal d an. Zum gleichen Zeitpunkt ist dem Ausgangsanschluß 503 das Signal bn<2:0> = not(d). Da somit an den Eingangsanschlüssen 201, 202 des Schaltnetzes 200 gleichzeitig die korrekten Signale anliegen, kann das Schaltnetz von einem Vorladezustand direkt in den logisch gültigen Zustand d' übergehen. Gleiches gilt dann für den Datenausgang 203, der ebenfalls direkt in seinen, den Registerausgängen entsprechenden, logisch gültigen Wert übergeht.

Die erfindungsgemäße integrierte Schaltung bzw. Schaltungsanordnung vermeidet somit in nachfolgenden Schaltungen Störungen oder einen erhöhten Schaltungsaufwand, um verzögerte Eingangssignale auszugleichen. Weiterhin werden überflüssige Signalwechsel vermieden. Physikalisch bedeutet dies, daß die jeweiligen elektrischen Kapazitäten niemals unnötig umgeladen werden, wodurch ein geringer Energieumsatz sichergestellt ist. Darüber hinaus hängt das Stromprofil des Schaltnetzes nicht von den jeweils zu verarbeitenden Daten ab, so daß diese Schaltungen resistent gegenüber Angriffen mit der differentiellen Stromprofilanalyse sind.

In Figur 8 ist beispielhaft der konstruktive Aufbau eines Daten-Latch dargestellt. Dieser besteht aus zwei C² MOS-Schaltern 850, 851, wobei der C²MOS -Schalter 851 als Rückkoppelinverter dient. Der prinzipielle Aufbau eines derartigen Daten-Latch ist bekannt, so daß auf eine nähere Beschreibung verzichtet wird. Im übrigen stellt Figur 8 lediglich ein Ausführungsbeispiel dar, welches auch einen anderen konstruktiven Aufbau haben könnte.

### Bezugszeichenliste

- CLK: Taktsignal
- n: Bitbreite
- SRS: Single-Rail-Signal
- DRS: Dual-Rail-Signal
- SZ: Speicherzelle
- SZE: Eingang Daten-Latch
- SZA1, SZA2: Ausgang Daten-Latch
- SZC1, SZC2: Taktsignaleingang

- 100: Register
- 101: Dateneingang
- 102: Datenausgang
- 103: Taktsignalanschluß
- 104, 105: Ausgangsleitung
- 110: Inverter

- 150, 151: C²MOS-Speicherzelle
- 152: Inverter
- 160, 161: C²MOS-Speicherzelle
- 162: Inverter

- 200: Schaltnetz
- 201, 202: Eingangsanschluß
- 203: Ausgangsanschluß
- 210: NAND-Gatter
- 220: NOR-Gatter

- 500: Register
- 501: Dateneingang
- 502, 503: Ausgangsanschluß
- 504: Taktsignalanschluß
- 510: Inverter
- 520: Schaltungsanordnung
- 525: Cascode Voltage Switch Logik CVSL
- 526, 527: Eingangsanschluß
- 528, 529: Ausgang

- 850, 851: C²MOS-Speicherzelle
- 852: Inverter

- a(<n:0>): Signal
- b (<n:0>): Signal
- bn(<n:0>): Signal
- z(<n:0>): Signal
- zn(<n:0>): Signal
- y (<n:0>): Signal
- yn (<n: 0>): Signal

## Patentansprüche

1. Integrierte Schaltung zur Umwandlung eines Single-Rail-Signals in ein Dual-Rail-Signal mit:
- einem Taktsignalanschluß (CLK),
- einem Dateneingang (501) mit einer Eingangsleitung, an den ein Single-Rail-Signal (a<n:0>) anlegbar ist,
- einem Datenausgang (502, 503), an dem ein Dual-Rail-Signal (b<n:0>, bn<n:0>) an zwei. Ausgangsleitungen abgreif bar ist,
- einem Mittel (500) zum Umwandeln des Single-Rail-Signals (a<n:0>) in das Dual-Rail-Signal (b<n:0>, bn<n:0>), welches zwischen dem Dateneingang (501) und dem Datenausgang (502, 503) verschaltet ist,
wobei das Mittel (500) zum Umwandeln des Single-Rail-Signals (a<n:0>) in das Dual-Rail-Signal (b<n:0>, bn<n:0>) umfaßt:
- eine Speicherzelle (SZ), deren Eingang (SZE) mit dem Dateneingang (501) der integrierten Schaltung verbunden ist und an dessen Ausgangsanschlüsse (SZA1, SZA2) im transparenten Zustand das logisch gültige Dual-Rail-Signal (b<n:0>, bn<n:0>) anliegt,
- eine zwischen den Ausgangsanschlüssen (SZA1, SZA2) der Speicherzelle (SZ) und dem Datenausgang (502, 503) der integrierten Schaltung angeordnete-Schaltungsanordnung (520), die das Vorladen der mit den Ausgangsanschlüssen (502, 503) verbundenen Ausgangsleitungen übernimmt und einen direkten Übergang von der Vorladephase in den logischen Zustand auf den Ausgangsleitungen und umgekehrt sicherstellt,
wobei die Schaltelemente der Speicherzelle (SZ) und der nachgeschalteten Schaltungsanordnung (520) mit dem Taktsignalanschluß (CLK) gekoppelt sind und mit dem gleichen Taktsignal beaufschlagt werden.

2. Integrierte Schaltung nach Anspruch 1, bei der nach jeder fallenden oder steigenden Taktflanke des Taktsignals (CLK) ein Vorladen der mit den Ausgangsanschlüssen (502, 503) verbundenen Ausgangsleitungen der integrierten Schaltung erfolgt.

3. Integrierte Schaltung nach Anspruch 1 oder 2, bei der die Speicherzelle (SZ) an einem ersten Taktsignaleingang (SZC1) das Taktsignal (CLK) zugeführt wird.

4. Integrierte Schaltung nach Anspruch 1, 2 oder 3, bei der dem Daten-Latch (SZ) an einem zweiten Taktsignaleingang (SZC2) das invertierte Taktsignal (CLK) zugeführt wird.

5. Integrierte Schaltung nach einem der Ansprüche 1 bis 4, bei der die Schaltungsanordnung (520) eine Cascode Voltage Switch-Logik (CVSL) aufweist, deren Eingangsanschlüsse (526, 527) mit dem Ausgang (SZA1, SZA2) der Speicherzelle (SZ) verbunden sind und deren Ausgangsanschlüsse (528, 529) die Ausgangsleitungen (502, 503) der integrierten Schaltung darstellen.

6. Integrierte Schaltung nach Anspruch 5, bei der die Schaltungsanordnung (520) einen erstes und ein zweites Schaltelement (TP1; TP2) aufweist, deren Steueranschlüsse jeweils mit dem Taktsignal (CLK) gekoppelt sind und deren Laststrecken zwischen einem ersten Versorgungspotentialanschluß (VDD) und je einer der mit den Ausgangsanschlüssen (502, 503) verbundenen Ausgangsleitungen verschaltet ist, wobei das erste und zweite Schaltelement (TP1; TP2) im transparenten Zustand der Speicherzelle (SZ) eingeschaltet sind.

7. Integrierte Schaltung nach Anspruch 5, bei der die Schaltungsanordnung (520) einen erstes und ein zweites Schaltelement (TN1; TN2) aufweist, deren Steueranschlüsse jeweils mit dem invertierten Taktsignal (CLK) gekoppelt sind und deren Laststrecken zwischen einem zweiten Versorgungspotentialanschluß (VSS) und je einer der mit den Ausgangsanschlüssen (502, 503) verbundenen Ausgangsleitungen verschalten ist, wobei das erste und zweite Schaltelement (TN1; TN2) im transparenten Zustand der Speicherzelle (SZ) eingeschaltet sind.

8. Integrierte Schaltung nach einem der Ansprüche 1 bis 7, bei der die Speicherzelle (SZ) ein Daten-Latch ist.

9. Schaltunsanordnung mit einer Mehrzahl an integrierten Schaltungen gemäß einem der Ansprüche 1 bis 8.

10. Verwendung der integrierten Schaltung nach einem der Ansprüche 1 bis 9,
um ein Single-Rail-Signal zur Erschwerung einer Stromprofilanalyse in ein Dual-Rail-Signal umzuwandeln.

## Claims

1. Integrated circuit for converting a single-rail signal into a dual-rail signal, having:
- a clock signal connection (CLK),
- a data input (501) having an input line to which a single-rail signal (a<n:0>) can be applied,
- a data output (502, 503) on which a dual-rail signal (b<n:0>, bn<n:0>) can be tapped off on two output lines,
- a means (500) for converting the single-rail signal (a<n:0>) into the dual-rail signal (b<n:0>, bn<n:0>), which is connected between the data input (501) and the data output (502, 503),
where the means (500) for converting the single-rail signal (a<n:0>) into the dual-rail signal (b<n:0>, bn<n:0>) comprises:
- a memory cell (SZ) whose input (SZE) is connected to the data input (501) on the integrated circuit and whose output connections (SZA1, SZA2), in the transparent state, provide the logically valid dual-rail signal (b<n:0>, bn<n:0>),
- a circuit arrangement (520) which is arranged between the output connections (SZA1, SZA2) of the memory cell (SZ) and the data output (502, 503) of the integrated circuit, precharges the output lines connected to the output connections (502, 503), and ensures a direct passage from the precharge phase to the logic state on the output lines, and vice versa, the switching elements in the memory cell (SZ) and in the downstream circuit arrangement (520) being coupled to the clock signal connection (CLK) and having the same clock signal applied to them.

2. Integrated circuit according to Claim 1, in which the integrated circuit's output lines connected to the output connections (502, 503) are precharged after each falling or rising clock edge of the clock signal (CLK).

3. Integrated circuit according to Claim 1 or 2, in which the clock signal (CLK) is supplied to a first clock signal input (SZC1) on the memory cell (SZ).

4. Integrated circuit according to Claim 1, 2 or 3, in which the inverted data signal (CLK) is supplied to a second clock signal input (SZC2) on the data latch (SZ) .

5. Integrated circuit according to one of Claims 1 to 4, in which the circuit arrangement (520) has a cascode voltage switch logic section (CVSL) whose input connections (526, 527) are connected to the output (SZA1, SZA2) of the memory cell (SZ) and whose output connections (528, 529) are the output lines (502, 503) from the integrated circuit.

6. Integrated circuit according to Claim 5, in which the circuit arrangement (520) has a first and a second switching element (TP1; TP2) whose control connections are respectively coupled to the clock signal (CLK) and whose load paths are connected between a first supply potential connection (VDD) and a respective one of the output lines connected to the output connections (502, 503), with the first and second switching elements (TP1; TP2) being on in the transparent state of the memory cell (SZ) .

7. Integrated circuit according to Claim 5, in which the circuit arrangement (520) has a first and a second switching element (TN1; TN2) whose control connections are respectively coupled to the inverted clock signal (CLK) and whose load paths are connected between a second supply potential connection (VSS) and a respective one of the output lines connected to the output connections (502, 503), with the first and second switching elements (TN1; TN2) being on in the transparent state of the memory cell (SZ).

8. Integrated circuit according to one of Claims 1 to 7, in which the memory cell (SZ) is a data latch.

9. Circuit arrangement having a plurality of integrated circuits according to one of Claims 1 to 8.

10. Use of the integrated circuit according to one of Claims 1 to 9 in order to convert a single-rail signal into a dual-rail signal to make current-profile analysis more difficult.

## Revendications

1. Circuit intégré pour la conversion d'un signal simple rail en un signal double rail, avec :
- une borne de signal d'horloge (CLK),
- une entrée de données (501) avec une ligne d'entrée, à laquelle un signal simple rail (a <n : 0>) peut être , appliqué,
- une sortie de données (502, 503), à laquelle un signal double rail (b <n . 0>, bn <n : 0>) peut être prélevé sur deux lignes de_sortie,
- un moyen (500) pour convertir le signal simple rail (a <n : 0>) en signal double rail (b <n : 0>, bn <n . 0>), qui est branché entre l'entrée de données (501) et la sortie de données (502, 503),
le moyen (500) pour la conversion du signal simple rail (a <n : 0>) en signal double rail (b <n : 0>, bn <n : 0>) comprenant :
- une cellule de mémoire (SZ), dont l'entrée (SZE) est reliée à l'entrée de données (501) du circuit intégré et aux bornes de sortie (SZA1, SZA2) de laquelle se trouve le signal double rail logiquement valide (b <n : 0>, bn <n : 0> lorsque la cellule de mémoire est à l'état transparent,
- un montage (520), qui est agencé entre les bornes de sortie (SZA1, SZA2) de la cellule de mémoire (SZ) et la sortie de données (502, 503) du circuit intégré, qui s'occupe de la précharge des lignes de sortie reliées aux bornes de sortie (502, 503) et qui assure une transition directs de la phase de précharge à l'état logique sur les lignes de sortie et inversement,
les éléments de commutation de la cellule de mémoire (SZ) et du montage placé du côté aval (520) étant couplés à la borne de signal d'horloge (CLK) et recevant le même signal d'horloge.

2. Circuit intégré selon la revendication 1, dans lequel il s'effectue, après chaque front descendant ou montant du signal d'horloge (CLK), une précharge des lignes de sortie, reliées aux bornes de sortie (502, 503), du circuit intégré.

3. Circuit intégré selon la revendication 1 ou 2, dans lequel le signal d'horloge (CLK) est envoyé à la cellule de mémoire (SZ) à une première entrée de signal d'horloge (SZC1).

4. Circuit intégré selon la revendication 1, 2 ou 3, dans lequel le signal d'horloge inversé (CLK) est envoyé à la cellule de mémoire (SZ) à une deuxième entrée de signal d'horloge (SZC2).

5. Circuit intégré selon l'une des revendications 1 à 4, dans lequel le montage (520) comporte une logique appelée Cascode Voltage Switch Logic (CVSL) dont les bornes d'entrée (526, 527) sont reliées à la sortie (SZA1, SZA2) de la cellule de mémoire (SZ) et dont les bornes de sortie (528, 529) représentent les lignes de sortie (502, 503) du circuit intégré.

6. Circuit intégré selon la revendication 5, dans lequel le montage (520) comporte un premier et un deuxième élément de commutation (TP1 ; TP2) dont les bornes de commande sont couplées à chaque fois au signal d' horloge (CLK) et dont les sections de charge sont branchées à chaque fois entre une première borne de potentiel d'alimentation (VDD) et l'une des lignes de sortie reliées aux bornes de sortie (502, 503), le premier et le deuxième élément de commutation (TP1 ; TP2) étant connectés lorsque la cellule de mémoire (SZ) est à l'état transparerit.

7. Circuit intégré selon la revendication 5, dans lequel le montage (520) comporte un premier et un deuxième élément de commutation (TN1 ; TN2) dont les bornes de commande sont couplées à chaque fois au signal d'horloge inversé (CLK) et dont les sections de charge sont branchées à chaque fois entre une deuxième borne de potentiel d'alimentation (VSS) et l'une des lignes de sortie reliées aux bornes de sortie (502, 503), le premier et le deuxième élément de commutation (TN1 ; TN2) étant connectés lorsque la cellule de mémoire (SZ) est à l'état transparent.

8. Circuit intégré selon l'une des revendications 1 à 7, dans lequel la cellule de mémoire (SZ) est un circuit de verrouillage de données.

9. Montage comportant plusieurs circuits intégrés selon l'une des revendications 1 à 8.

10. Utilisation du circuit intégré selon l'une des revendications 1 à 9 pour convertir un signal simple rail en un signal double rail afin de rendre une analyse de consommation de courant plus difficile.
